Europäisches Patentamt

European Patent Office

Office européen des brevets

(19)

(11) Numéro de publication : **0 188 838**
**B1**

(12) **FASCICULE DE BREVET EUROPÉEN**

(45) Date de publication du fascicule du brevet :
17.08.88

(51) Int. Cl.⁴ : **H 01 L 23/04, H 01 L 23/48**

(21) Numéro de dépôt : 85202039.5

(22) Date de dépôt : 10.12.85

(54) **Boîtier pour composant électronique.**

(30) Priorité : 21.12.84 FR 8419660

(43) Date de publication de la demande :
30.07.86 Bulletin 86/31

(45) Mention de la délivrance du brevet :
17.08.88 Bulletin 88/33

(84) Etats contractants désignés :
CH DE FR GB LI NL

(56) Documents cités :
EP-A- 0 069 505
EP-A- 0 080 041
EP-A- 0 098 176
DE-A- 3 414 961
FR-A- 2 536 209
GB-A- 1 558 764
US-A- 4 293 451
US-A- 4 338 621

(73) Titulaire : Laboratoires d'Electronique et de Physique
Appliquée L.E.P.
3, Avenue Descartes
F-94450 Limeil-Brévannes (FR)
FR
N.V. Philips' Gloeilampenfabrieken
Groenewoudseweg 1
NL-5621 BA Eindhoven (NL)
CH DE GB LI NL

(72) Inventeur : Monnier, Michel, Jean-Claude
Société Civile S.P.I.D. 209 rue de l'Université
F-75007 Paris (FR)

(74) Mandataire : Landousy, Christian et al
Société Civile S.P.I.D. 209, Rue de l'Université
F-75007 Paris (FR)

## Description

L'invention concerne un boîtier pour composant électronique, incluant un substrat en céramique sur lequel est déposé un circuit à couches multiples réalisé par sérigraphie à l'aide de matériaux alternativement conducteurs et isolants et destiné à assurer la liaison entre les bornes du composant électronique fixé sur le substrat et les broches de fixation du boîtier logées sur le substrat dans des trous métallisés munis de couronnes conductrices sur chaque face du substrat, la métallisation des trous et les couronnes étant réalisées par sérigraphie à l'aide d'un matériau conducteur compatible avec le matériau conducteur composant le circuit multicouche.

L'invention trouve son application dans la réalisation de boîtiers pour circuits intégrés à très grand nombre de bornes d'entrée et sortie, les qualités primordiales demandées à ces boîtiers étant la facilité de réalisation, le rendement de fabrication, le faible coût, la fiabilité électrique et la solidité mécanique, de façon à pouvoir être fabriqués en grande série et vendus dans des domaines grand-public.

Un dispositif comportant un tel circuit multicouches est connu du brevet US N° 3,549,784. Le dispositif décrit dans le document cité inclut un circuit multicouches réalisé par sérigraphie sur un substrat en céramique, par exemple en alumine. Ce circuit est formé de couches alternativement conductrices et isolantes, les couches conductrices étant constituées de réseaux de conducteurs et les couches isolantes étant destinées à noyer les conducteurs. Les couches isolantes sont composées d'une céramique compatible avec celle du substrat. Après réalisation des différentes couches selon la configuration voulue pour le circuit, toute la structure composite du substrat en matière céramique, des couches métalliques non cuites et des couches céramiques isolantes est chauffée à une température de 1630°C pendant deux heures dans une atmosphère d'hydrogène et d'azote pour faire fritter les composants métalliques et céramiques. On obtient alors une structure dite « co-cuite ».

Selon le document cité, des broches de composants ou des broches de connexion peuvent être introduites dans des trous métallisés pratiqués dans le substrat, pour y être soudées. La métallisation des trous est faite à l'aide du même matériau et en même temps que l'une des couches conductrices du circuit. Le matériau diffuse dans les trous par aspiration. Aucune composition de métaux propres à assurer la soudure ou la brasure n'est donnée.

Or une telle structure co-cuite présente un très grave inconvénient pour l'application à la réalisation de base de boîtier. Cet inconvénient réside dans le fait que la structure obtenue n'est pas plane : elle est cambrée. Le document cité enseigne qu'une solution à ce problème peut être apportée en réalisant au verso du substrat une couche métallique à une position telle qu'elle s'oppose aux déformations dues aux configurations du recto.

Cependant un article intitulé « Narumi va automatiser la fabrication de ses substrats céramiques multicouches « co-cuits » publié par J. P. Della Mussia dans Electronique Actualités N° 772 du 2 novembre 1984, nous apprend que les rendements de fabrication moyens des substrats en céramique du type co-cuits ne dépassent pas 30 %, car le retrait qui apparaît à la cuisson et qui peut atteindre 17 % des dimensions, entraîne fréquemment la rupture des conducteurs.

Cet inconvénient majeur est dû au fait que la technologie adoptée implique une cuisson à très haute température, ce qui entraîne d'ailleurs d'autres inconvénients non négligeables.

Ainsi, la cuisson à très haute température rend impérative l'utilisation de métaux réfractaires tels que le tungstène ou l'alliage molybdène-manganèse pour constituer les couches conductrices. Or ces métaux sont électriquement mauvais conducteurs. D'après la demande de brevet citée, d'autres métaux tels que le platine ou le palladium peuvent être utilisés et cuits à l'air à des températures plus basses. Mais, outre que ces métaux sont extrêmement onéreux, des températures au moins égales à 1300°C sont indispensables pour assurer le frittage des couches isolantes céramiques, ce qui est encore une température extrêmement élevée. Dans ces conditions, un métal comme le cuivre, qui est pourtant bien meilleur conducteur tout en étant beaucoup moins onéreux, ne peut être utilisé du fait qu'il fond à une trop basse température.

En sorte que le circuit proposé dont la structure devait résoudre, comme il est dit dans l'article de Della Mussia, le problème de la simplicité de réalisation de la base de boîtier grâce au fait qu'il n'implique qu'une seule cuisson, et dont la structure devait résoudre le problème de la solidité mécanique grâce au fait que les couches isolantes sont en céramique, conduit en réalité au résultat inverse : les coûts de fabrication sont augmentés du fait qu'un rendement aussi faible que 30 % est obtenu et du fait que des matériaux onéreux sont utilisés, et la solidité mécanique n'est pas obtenue puisque ces circuits sont sujets à la rupture des conducteurs.

D'autre part de sérieux problèmes, non résolus par le brevet cité, se posent concernant le scellement des broches dans leur logement. En effet, la solidité de ce scellement, qui est impérative, dépend en grande partie de la méthode utilisée pour percer les trous, pour les métalliser et pour fixer les broches dans les trous à l'aide d'un matériau de scellement. La solidité dépend également de la forme de la broche.

Un problème se pose enfin dans la fixation du composant électronique sur la base de boîtier et dans le scellement étanche ou hermétique d'un capot de protection de ce composant. Ce problème n'est pas résolu par le brevet cité.

C'est pourquoi la présente invention propose de résoudre le problème de la fabrication de tels boîtiers en utilisant des solutions radicalement contraires aux solutions préconisées par l'art antérieur.

Selon la présente invention, ce problème est résolu par un boîtier tel que défini dans le préambule caractérisé en ce que le matériau conducteur est un composé sérigraphiable formé au moins de cuivre et d'un matériau vitrocristallin, à cuire en atmosphère neutre à une température inférieure à la température de fusion du cuivre, en ce que le matériau isolant est un composé sérigraphiable vitrocristallin à cuire en atmosphère neutre à une température compatible avec le matériau conducteur, ce matériau isolant présentant un coefficient de dilatation adapté à celui du substrat jusqu'à sa température de cuisson, en ce que la dernière couche du circuit est une couche protectrice isolante vitrocristalline, en ce que les broches présentent la forme d'une tige munie d'une tête plate, la tige traversant le substrat dans les trous et dépassant d'une des faces d'une longueur suffisant à assurer la fixation du boîtier, et la tête plate prenant appui sur la couronne située sur l'autre face du substrat, en ce que les broches sont fixées à l'aide d'un alliage métallique compatible avec la métallisation des trous et des couronnes conductrices, dont la température de fusion est inférieure à, ou de l'ordre de, la température de cuisson des couches du circuit, en ce que, le composant électronique étant placé sur le substrat, les bornes de ce composant sont reliées par des fils souples aux extrémités des conducteurs laissées libres lors de l'élaboration du circuit multicouches, et en ce que le composant électronique est protégé par un capot.

Un procédé de réalisation d'un tel boîtier est également proposé. Ce procédé étant caractérisé en ce qu'il comprend les étapes de :

a) formation d'un substrat en céramique,

b) perçage dans le substrat, de trous destinés à servir de logement aux broches de fixation du boîtier, tout en ménageant une plage prévue pour recevoir le composant électronique,

c) métallisation des trous, et formation de couronnes conductrices autour des trous sur chaque face du substrat, ces opérations étant réalisées par sérigraphie à l'aide d'une encre conductrice constituée au moins de cuivre et d'un matériau vitrocristallin, à cuire sous atmosphère neutre à une température inférieure à la température de fusion du cuivre, et ces opérations comprenant le dépôt au niveau du débouché des trous d'une quantité de l'encre conductrice, la diffusion de cette encre dans les trous, par exemple par aspiration, et la cuisson des couches ainsi réalisées,

d) dépôt d'une première couche conductrice, selon une configuration prévue pour former des conducteurs destinés à assurer la liaison entre une partie des bornes du composant électronique et une partie des broches, en laissant libre la plage prévue pour recevoir le composant électronique, ce dépôt étant réalisé par sérigraphie à l'aide d'une encre conductrice au cuivre identique à, ou compatible avec, l'encre de métallisation des trous et des couronnes, et cuisson de cette couche,

e) dépôt d'une couche isolante, selon une configuration prévue pour isoler la précédente couche conductrice de la couche conductrice suivante, en laissant libre la plage prévue pour recevoir le composant électronique, ainsi que les couronnes conductrices et les extrémités des conducteurs se trouvant en regard des bornes du composant, ce dépôt étant réalisé par sérigraphie à l'aide d'une encre isolante vitrocristalline à cuire sous atmosphère neutre à une température compatible avec celle de l'encre conductrice, cette encre présentant un coefficient de dilatation très voisin de celui du substrat jusqu'à la température de cuisson de la couche, et cuisson de cette couche,

f) dépôts alternés de couches respectivement conductrices et isolantes selon une configuration prévue pour obtenir le réseau de conducteurs nécessaire à la connexion des bornes du composant électronique aux broches du boîtier, en laissant libre la plage prévue pour recevoir le composant électronique, ainsi que les couronnes conductrices et les extrémités des conducteurs se trouvant en regard des bornes du composant, ces dépôts étant réalisés par sérigraphie à l'aide d'encres alternativement conductrices et isolantes identiques à, ou compatibles avec, les encres formant les couches précédentes, en terminant par une couche protectrice isolante, et cuisson de ces couches une à une,

g) protection provisoire des zones constituées par la plage prévue pour le composant électronique et les extrémités des conducteurs en regard de cette plage, à l'aide d'un vernis résistant à la soudure prévue pour la fixation des broches,

h) mise en place des broches métalliques formées d'une tige munie d'une tête plate, la tige traversant le substrat dans les trous et dépassant d'une des faces d'une longueur suffisant à assurer la fixation du boîtier, et la tête plate prenant appui sur la couronne située sur l'autre face du substrat, et soudure des broches à l'aide d'un alliage métallique compatible avec la métallisation des trous et des couronnes, dont la température de fusion est inférieure à, ou de l'ordre de, la température de cuisson des couches du circuit,

i) élimination du vernis de protection,

j) mise en place et fixation du composant électronique sur la plage réservée sur le substrat,

k) câblage de fils métalliques souples entre les bornes du composant électronique et les extrémités laissées libres des conducteurs du circuit multicouches,

l) fixation du capot de protection du composant électronique.

Dans ces conditions, le circuit multicouches, réalisé à l'aide de couches vitrocristallines de température de cuisson très inférieure à la température de cuisson des couches céramiques et de cœfficient de dilatation adapté à celui du substrat jusqu'à la température de cuisson, ces couches étant cuites une à une, montre des qualités bien supérieures à celles des circuits céramiques co-cuits. En effet, les bases munies de ces circuits sont dépourvues de tension, elles ne sont donc pas cambrées. Il n'est donc pas nécessaire de prévoir des couches supplémentaires destinées à compenser la cambrure. Les connexions entre couches, et les réseaux de connecteurs sont solides et électriquement fiables.

La réalisation d'une cuisson après le dépôt de chaque couche ne rend pas la fabrication de la base de boîtier plus compliquée ou plus onéreuse, car l'implication de faibles températures et l'utili-sation de matériaux peu coûteux permettent en réalité de diminuer les coûts dans des proportions considérables, résultats qui sont encore améliorés par des rendements de fabrication proches de 100 %.

La qualité électrique des circuits est également grandement améliorée grâce à l'utilisation du cuivre en tant que matériau conducteur, la conductivité du cuivre étant environ 10 fois supérieure à celle du tungstène par exemple.

La qualité du brochage du boîtier est aussi améliorée par la forme des broches d'une part et par les matériaux proposés pour le scellement d'autre part. Ainsi une très bonne solidité mécanique et une parfaite liaison électrique, qui sont des qualités essentielles pour un boîtier sont obtenues, ces qualités étant acquises à l'aide de matériaux simples et peu coûteux.

Mais surtout le scellement des broches et le scellement du capot de protection du composant électronique par l'une des méthodes préconisées par l'invention permet d'obtenir un boîtier étanche ou même hermétique qui supporte de fortes températures et est donc conforme aux normes les plus sévères.

L'invention sera mieux comprise à l'aide de la description suivante illustrée par les figures annexées dont :

- la figure 1 qui représente en coupe une partie d'un boîtier selon l'invention ;

- la figure 2 qui représente en coupe une variante de réalisation d'une même partie d'un boîtier selon l'invention ;

- les figures 3 qui représentent en coupe la même partie d'un boîtier selon l'invention au cours de différentes étapes du procédé de réalisation, et de sa variante.

Chacune des figures représente sensiblement la coupe d'une moitié du boîtier, la partie non représentée étant symétrique de la partie représentée en ce qui concerne la composition des éléments constituant le boîtier.

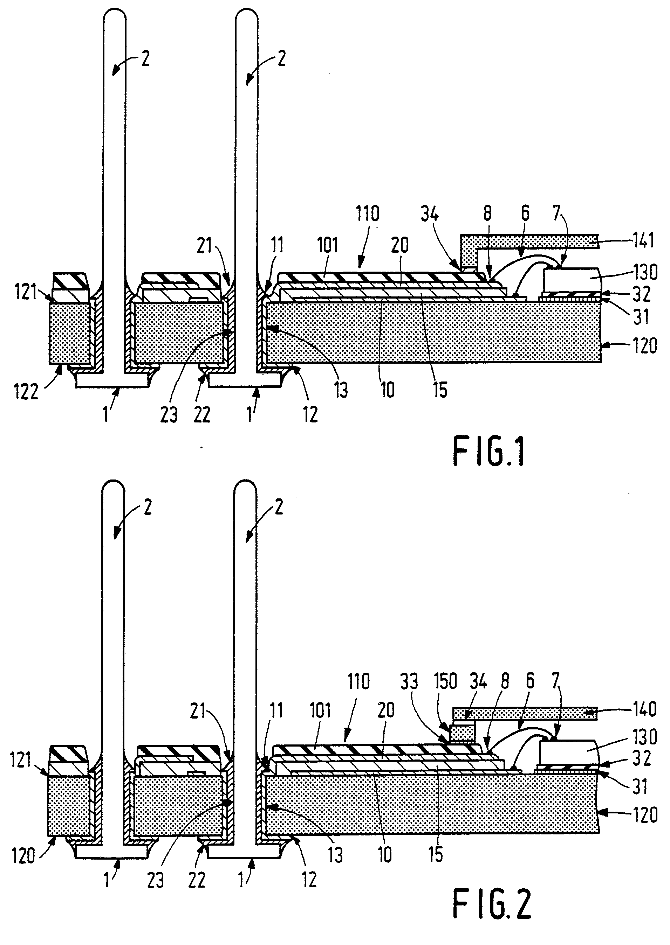

Tel que représenté en coupe sur la figure 1, le boîtier selon l'invention comprend un substrat en céramique 120 supportant en sa partie centrale un composant électronique 130, un circuit multicouches 110 destiné à assurer les liaisons électriques entre le composant électronique et les broches 2. Un capot 141 qui peut être en céramique garantit la protection du composant électronique.

Selon une variante de ce boîtier représenté figure 2, le capot est formé de deux parties, une entretoise 150 et un couvercle 140.

Le composant électronique 130 est le plus souvent un circuit intégré à grande échelle (VLSI) réalisé sur un matériau semi-conducteur et présentant un grand nombre de bornes 7 d'entrée et sortie. Ce nombre est à ce jour de l'ordre de 144. Mais la demande grandissante pour des circuits toujours plus complexes fait que, dans un proche avenir, ce nombre pourrait atteindre 300.

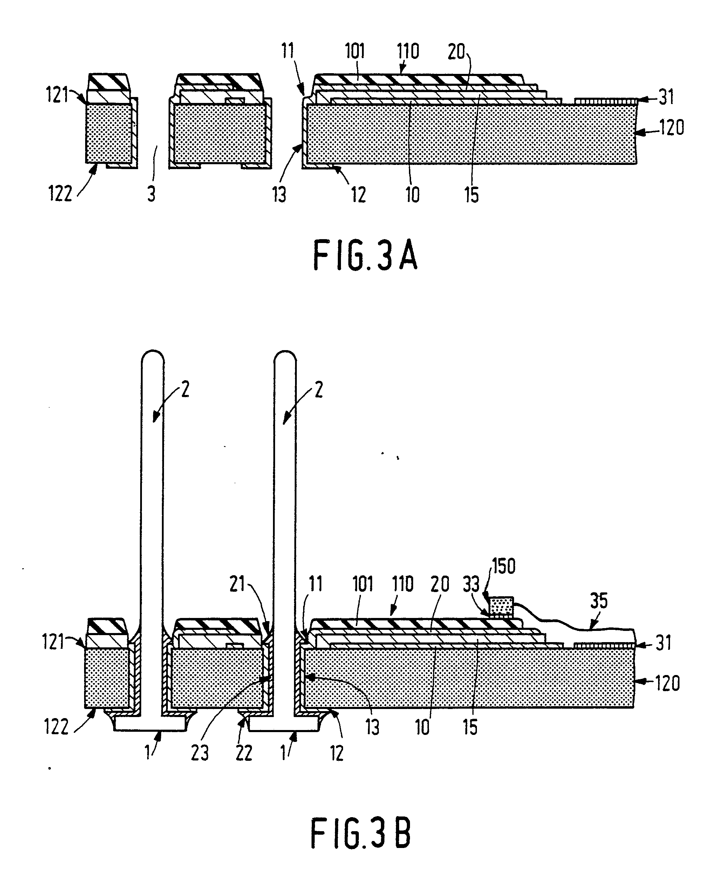

Le boîtier muni de ce composant est connecté à un ensemble électronique, le plus souvent une carte imprimée, soit par l'intermédiaire d'un socle (en anglais : pin grid array socket), soit directement par soudure sur la carte. Dans l'un et l'autre cas, les fonctions de connexion électrique et de fixation mécanique sont assurées par les broches 2 implantées dans des trous 3 pratiqués dans le substrat 120, comme il est montré figure 3a.

Le nombre des broches 2 est au moins égal au nombre des bornes 7 du composant électronique. Ce nombre élevé, et un écartement minimal nécessaire pour éviter les courts-circuits lors du raccordement du boîtier avec le dispositif externe, font qu'il n'est pas possible de placer toutes les broches sur un même rang. Elle sont donc réparties sur plusieurs rangs à la périphérie du substrat.

La liaison entre les broches métalliques 2 et les bornes 7 du composant électronique est assurée pour une part, par le réseau 110 de conducteurs réalisé sur le substrat 120 par sérigraphie, et pour une autre part, par des fils métalliques souples 6 reliant l'extrémité 8 des conducteurs auxdites bornes 7.

Le nombre des conducteurs, qui doit donc pouvoir atteindre 300, et le pas de leur extrémité 8 qui est de l'ordre du dixième de mm, rendent impératif le fait d'utiliser plusieurs niveaux pour former le réseau sérigraphié 110. Chaque niveau conducteur 10, 20,... comporte donc une partie des conducteurs reliée à une partie des broches 2, et est séparé du niveau conducteur suivant par une couche électriquement isolante 15, qui peut d'ailleurs être munie d'ouvertures pour faire communiquer éventuellement deux niveaux conducteurs contigus. L'ensemble du réseau 110 forme ainsi un circuit multicouches.

Afin d'éliminer les problèmes inhérents au type de circuit multicouches choisi pour réaliser le boîtier selon l'art antérieur, un nouveau type de matériaux sérigraphiables est choisi pour réaliser le boîtier selon l'invention et un nouveau procédé de réalisation est proposé.

Conformément à l'invention, un composé conducteur apte à former une encre sérigraphiable pour réaliser les couches conductrices 10, 20,... est constitué d'une part de grains de cuivre et d'autre part d'un liant vitreux. L'encre obtenue à l'aide de ce composé admet une cuisson sous atmosphère non oxydante, par exemple l'azote, à une température inférieure à la température de fusion du cuivre.

Un composé conducteur répondant à ces conditions peut être par exemple le composé décrit dans le brevet GB-A- 1,489,031 ou dans le brevet anglais 2,037,270.

D'autre part, le composé isolant apte à former une encre sérigraphiable pour réaliser les couches isolantes 15..., est constitué d'au moins une phase vitreuse. L'encre obtenue à l'aide de ce composé admet une cuisson sous atmosphère neutre, par exemple l'azote, à une température compatible avec l'encre utilisée pour former les couches conductrices 10, 20,...

Un composé isolant répondant à ces conditions peut être par exemple le composé décrit dans le brevet US-A-4,152,282 ou dans le brevet US-A-4,323,652.

Les différents composés cités sont particulièrement intéressants pour réaliser le boîtier selon l'invention du fait qu'ils répondent aux conditions en admettant une température de cuisson sous azote comprise entre 850°C et 950°C et du fait qu'ils sont compatibles entre eux. Ils présentent en outre de nombreux avantages.

D'une part les couches conductrices au cuivre ainsi réalisées présentent une très bonne conductivité électrique de l'ordre de 1,5 milliohms par carré, pour des conducteurs d'épaisseur 20μm (20 microns).

D'autre part, les couches isolantes vitrocristallines présentent un cœfficient de dilatation thermique qui est extrêmement proche de celui du substrat en céramique et cela jusqu'à leur température de cuisson. Les boîtiers obtenus sont donc parfaitement plans. Les différentes couches constituant le boîtier étant dépourvues de tensions mécaniques, le rendement de fabrication est proche de 100 %.

Il faut noter cependant, que la composition des couches tant conductrices qu'isolantes, qui est proposée à titre d'exemple, impose que ces couches soient cuites une à une. Mais les faibles températures nécessaires à la cuisson et le faible coût des matériaux employés permettent d'obtenir néanmoins des coûts de fabrication extrêmement réduits.

De préférence, une couche isolante de protection 101 est réalisée sur la dernière couche conductrice à l'aide d'une composition apte à former une encre sérigraphiable constituée d'une phase vitreuse, admettant une basse température de cuisson, de l'ordre de 550°C. Cette cuisson devant être effectuée sous atmosphère non oxydante. Un composé isolant répondant à ces conditions peut être par exemple le composé décrit dans la demande de brevet US-SN 745.734, équivalente à EP-A-167198, déposée le 18.06.85, date de publication 08.01.86.

Dans un exemple de réalisation, chaque couche de conducteurs est réalisée en une seule passe de sérigraphie et présente alors une épaisseur d'environ 15μm après cuisson. Chaque couche isolante, séparant deux couches conductrices, est réalisée en deux passes, avec une cuisson intermédiaire, et présente après la cuisson finale une épaisseur d'environ 40 μm.

Tels que représentés sur la figure 3a, les trous 3 pratiqués dans le substrat 120 et destinés à recevoir les broches 2, peuvent être réalisés par différents procédés, par exemple par effet laser, ou encore par poinçonnage lors de l'élaboration du substrat.

Cette dernière méthode est préférée du fait qu'elle est simple, et du fait qu'elle fournit des trous dont les parois présentent le même état de surface que celui du substrat et peuvent donc subir directement la métallisation nécessaire à la préparation de la fixation des broches.

Au contraire le perçage au laser provoque une vitrification superficielle des parois des trous formant une couche peu adhérente et craquelée. Cette couche peut être éliminée par exemple par un traitement thermique, ou bien encore en déposant sur les parois des trous deux couches de la métallisation décrite ci-après, la première couche contenant une teneur augmentée jusqu'à 10 % en poids du liant vitreux, et la seconde couche une teneur normale (2 % environ de liant vitreux en poids).

De préférence, après préparation d'un substrat muni de trous, la métallisation des trous, à l'aide d'une encore au cuivre identique à, ou compatible avec l'encre prévue pour réaliser les couches conductrices 10, intervient avant la réalisation du circuit multicouches. A cet effet, l'encre sérigraphiable destinée à cette métallisation est diffusée dans le trou 3 par exemple par aspiration de manière à enduire les parois de ce trou, puis elle subit une cuisson. Des couronnes conductrices sérigraphiées 11 et 12 sont réalisées, au cours de la même opération, autour des trous 3, sur chacune des faces 121 et 122 respectivement, du substrat 120.

Un plan de masse métallique 31, réalisé sur la partie centrale de la face 121 du substrat, par exemple à l'aide d'une encre au cuivre citée, est prévu pour recevoir le composant électronique 130. Le circuit multicouches est réalisé sur cette même face 121 autour du composant électronique, et les tiges des broches 2 sortent également du côté de cette face 121. Une telle disposition permet de laisser libre la seconde face 122 du substrat dans le but d'y fixer un dispositif radiateur servant à éliminer la chaleur produite par le composant électronique en fonctionnement et qui est nuisible à la durée de vie des éléments de ce composant électronique. Ce dispositif radiateur n'est pas représenté sur les figures, comme ne faisant pas partie à proprement parler, de l'invention.

Le capot de protection du composant électronique peut être formé d'une partie évidée 141 comme il est représenté sur la figure 1, ou bien d'une entretoise 150 et d'un couvercle 140, comme il est représenté sur la figure 2.

La fixation du capot 141 ou du couvercle 140, est en général la dernière opération de la réalisation du boîtier. Mais dans le cas où le capot est en deux parties, l'entretoise 150 est fixée sur la couche de protection 101 précisément à l'aide d'une couche 33 identique à ou compatible avec la couche 101, donc à basse température, environ 550°C. L'emploi d'un capot en deux pièces n'est donc compatible qu'avec une méthode de fixation des broches, méthode qui sera décrite plus loin, selon laquelle les températures impliquées ne dépassent pas 550°C, car l'entretoise 150 est de préférence fixée sur la couche 101 avant la fixation des broches.

Afin d'éviter l'arrachement des broches, qui peut se produire lorsque le boîtier est mis en place puis enlevé de son socle plusieurs fois de suite, par exemple au cours des cycles de tests du composant électronique, une nouvelle forme des broches est proposée. Selon l'invention, les broches présentent la forme d'une tige munie d'une tête plate, la forme de la broche se rapprochant alors de la forme d'un clou à tête plate. La broche est introduite dans le trou métallisé 3 de manière à ce que la tête plate 1 prenne appui sur la seconde face 122 du substrat, le diamètre de cette tête 1 étant supérieur au diamètre du trou 3. La tige de la broche dépasse de la face 121 d'une longueur convenant à assurer la fixation du boîtier sur son socle par exemple, ou bien sa soudure sur une carte imprimée.

De par cette forme particulière, les broches du boîtier selon l'invention sont ainsi particulièrement résistantes à l'arrachement. Un métal apte à former les broches est par exemple le fer-nickel-cobalt.

La soudure des broches intervient, lorsque le composant électronique est fragile, ce qui est fréquent, avant la fixation de ce dernier sur son plan de masse. Durant l'opération de soudure des broches, le plan de masse 31 et les extrémités B des conducteurs doivent alors être protégés. Cette protection peut être assurée par exemple, par le dépôt de quelques gouttes d'un vernis plastique résistant à la soudure choisie, et ne laissant aucune trace après leur élimination de manière à ne pas gêner la soudure ultérieure de ces éléments.

Des produits convenant à assurer cette fonction sont par exemple un vernis du type pelable, ou bien un vernis copolymère de polyméthacrylate de méthyle et de butyle complètement soluble dans l'acétone. Ces produits peuvent d'ailleurs être utilisés également éventuellement pour protéger le boîtier terminé, lors du stockage.

Pour la fixation proprement dite des broches sur le substrat préparé comme il a été décrit précédemment, trois méthodes sont proposées à titre d'exemple. Chacune de ces méthodes comprend l'étamage préalable des broches, par exemple par galvanoplastie.

Selon la première méthode, les broches sont soudées à l'aide de soudure étain-plomb (60/40) qui vient se placer dans la position notée 23 sur la figures 1, 2 ou 3b. Cette méthode comprend la mise en place des broches 2 préalablement étamées dans les trous 3 métallisés, leur maintien par un montage approprié non décrit, car ne faisant pas partie de l'invention, et leur fixation par la soudure. Cette fixation peut être faite par exemple « au tremper » dans un bain de la soudure étain-plomb citée, à 230°C pendant 5 à 8 secondes, à l'aide d'un flux non activé. Une autre technique dite « à la vague » peut également être utilisée. Après nettoyage du flux, et élimination du vernis de protection des zones métalliques, la base de boîtier ainsi constituée, est prête à recevoir le composant 130, les fils de raccordement 6 et le capot de protection 141 comme représenté figure 1 lorsque ce capot est formé d'une pièce unique, ou bien 140 comme représenté figure 2 lorsque ce capot est composé de deux pièces.

Cependant, il peut se trouver que la métallisation des trous 13 et des couronnes 11 et 12 soit oxydée. Un traitement doit alors être effectué avant la soudure des broches. Ce traitement peut être choisi parmi ceux qui sont connus de l'homme de l'art pour éliminer l'oxyde en surface des couches de cuivre. On citera par exemple l'immersion de la base de boîtier dans une solution à 120 g/l de persulfate d'ammonium additionnés de 5 g/l d'acide sulfurique, le rinçage dans l'eau désionisée, le séchage à l'air comprimé puis à l'étuve sous azote à 80°C.

Les opérations ultérieures permettant la finition du boîtier doivent être compatibles avec la température à laquelle les broches ont été fixées.

C'est pourquoi selon cette première méthode de fixation des broches, le montage du composant électronique se fait par le collage de la face arrière de ce dernier sur le plan de masse au cuivre, par le moyen d'une colle conductrice à l'argent. Le collage est effectué au four sous azote pour éviter l'oxydation du cuivre.

Il est suivi par le câblage des fils d'or 6 qui assurent la connexion entre les bornes 7 et les extrémités 8 des conducteurs. Ce câblage peut être effectué par exemple à l'aide d'une machine thermo-sonique avec ou sans chauffage, du seul fait de l'énergie ultra-sonique, les extrémités des conducteurs étant dépourvues d'oxydation.

La dernière opération est la fixation du capot évidé 141 ou bien la fixation du couvercle 140. Dans le cas où la première méthode de fixation des broches est utilisée, cette dernière opération comprend le dépôt d'un cordon de colle époxy pré-polymérisée sur le bord du capot ou du couvercle et la fixation de l'élément concerné par polymérisation à 150°C pendant 15 mn sous atmosphère d'azote. Ce type de scellement procure une très bonne étanchéité du capot.

Le boîtier réalisé par cette première méthode qui inclut la fixation des broches à la soudure étain-plomb à 230° et la fixation du capot à la colle époxy, ne peut être reporté sur les cartes imprimées que par l'intermédiaire du socle dit « pin grid array socket ». En effet, une soudure directe sur les cartes imprimées nécessiterait un second passage « à la vague », c'est-à-dire 5 à 10 secondes à 240°C. Or cette température dépasse la température de refusion de la soudure étain-plomb qui est de 183°C. La soudure des broches effectuée selon cette première méthode ne résisterait donc pas à la soudure sur les cartes imprimées.

C'est pourquoi la présente invention propose une seconde et une troisième méthode de fixation des broches.

Selon la seconde méthode, avant de procéder à la fixation des broches, les couronnes en cuivre 11 et 12 entourant les trous 3, reçoivent une métallisation supplémentaire réalisée par sérigraphie d'une encre incluant un alliage étain-plomb-argent (dans les proportions respectives de 10 %, 88 % et 2 % en poids) et contenant un flux moyennement actif nécessaire au bon mouillage du cuivre. Cette pâte est appliquée de chaque côté du substrat de manière à assurer l'apport d'une quantité d'alliage suffisante pour le remplissage correct de l'intervalle 23 (figures 1, 2 et 3b) entre la paroi du trou et la broche, et à assurer la formation de congès de soudure 21 et 22 entre cette broche et les couronnes. La refusion est effectuée à 320°C pendant 20 à 40 secondes dans un four à passage sous atmosphère d'azote. Les broches ainsi fixées peuvent alors résister à un réchauffage jusqu'à 280°C sans risque de refusion.

Lorsque cette seconde méthode de fixation des broches est utilisée, le boîtier selon l'invention peut donc être fixé par soudure sur les cartes imprimées. Cependant la fixation du composant électronique, des fils, et du capot se fait comme il a été décrit à la suite de la première méthode de fixation.

Selon la troisième méthode de fixation des broches, des préformes circulaires, sensiblement de la forme et des dimensions des couronnes 12 sont réalisées, en un alliage argent-cuivre-nickel dans les proportions respectives de 71,15 %, 28,1 % et 0,75 % en poids. Cet alliage ternaire a un intervalle de température entre solidus et liquidus compris entre 780°C et 795°C, qui permet un cycle de fusion peu critique. Chaque broche est insérée dans le trou métallisé correspondant, en interposant la préforme circulaire, entre la tête 1 de la broche en forme de clou et la face 122 du substrat. La soudure se fait dans un four à passage avec une grande vitesse, pendant un temps d'environ 30 secondes. les brasures obtenues avec des préformes de 0,09 mm d'épaisseur sont de très bonne qualité.

Selon cette troisième méthode de fixation des broches, le composant électronique est fixé sur le plan de masse par refusion d'un eutectique or-silicium à 420-450°C. Les fils d'or sont fixés par la méthode décrite précédemment puis le capot est enfin assujetti par une soudure or-étain à 350°C, ce qui procure un scellement absolument hermétique, de qualité encore supérieure à celle qui est obtenue par l'une des deux premières méthodes.

Ces différentes méthodes de fabrication du boîtier selon l'invention ont été citées à titre d'exemples non limitatifs, mais d'autres méthodes peuvent être imaginées sans pour autant sortir du cadre de la présente invention tel que défini par les revendications ci-après annexées.

## Revendications

1. Boîtier pour composant électronique, incluant un substrat en céramique sur lequel est déposé un circuit à couches multiples réalisé par sérigraphie à l'aide de matériaux alternativement conducteurs et isolants et destiné à assurer la liaison entre les bornes du composant électronique fixé sur le substrat et les broches de fixation du boîtier logées sur le substrat dans des trous métallisés munis de couronnes conductrices sur chaque face du substrat, la métallisation des trous et les couronnes étant réalisées par sérigraphie à l'aide d'un matériau conducteur compatible avec le matériau conducteur composant le circuit multicouche, caractérisé en ce que le matériau conducteur est un composé sérigraphiable formé au moins de cuivre et d'un matériau vitrocristallin à cuire sous atmosphère neutre à une température inférieure à la température de fusion du cuivre, en ce que le matériau isolant est un composé sérigraphiable vitrocristallin à cuire sous atmosphère neutre à une température compatible avec le matériau conducteur, ce matériau isolant présentant un cœfficient de dilatation adapté à celui du substrat jusqu'à sa température de cuisson, en ce que la dernière couche du circuit est une couche protectrice isolante vitrocristalline, en ce que les broches présentent la forme d'une tige munie d'une tête plate, la tige traversant le substrat dans les trous et dépassant d'une des faces d'une longueur suffisant à assurer la fixation du boîtier, et la tête plate prenant appui sur la couronne située sur l'autre face du substrat, en ce que les broches sont fixées à l'aide d'un alliage métallique compatible avec la métallisation des trous et des couronnes, dont la température de fusion est inférieure à, ou de l'ordre de, la température de cuisson des couches du circuit, en ce que, le composant électronique étant placé sur le substrat, les bornes de ce composant sont reliées par des fils souples aux extrémités des conducteurs laissées libres lors de l'élaboration du circuit multicouches, et en ce que le composant électronique est protégé par un capot.

2. Boîtier selon la revendication 1, caractérisé en ce que le substrat est en alumine.

3. Boîtier selon l'une des revendications 1 ou 2, caractérisé en ce que les broches sont en fer-nickel-cobalt, étamées en surface.

4. Boîtier selon l'une des revendications 1 à 3, caractérisé en ce que le composant électronique est fixé sur un plan de masse en cuivre réalisé sur la même face du substrat que le circuit multicouches, par sérigraphie à l'aide d'une encre conductrice au cuivre identique à, ou compatible avec, l'encre conductrice du circuit multicouches.

5. Boîtier selon l'une des revendications 1 à 4, caractérisé en ce que l'alliage métallique de fixation des broches est l'étain-plomb.

6. Boîtier selon l'une des revendications 1 à 4, caractérisé en ce que l'alliage métallique de fixation des broches est l'étain-plomb-argent inclus dans un composé sérigraphiable.

7. Boîtier selon l'une des revendications 5 ou 6, dans la mesure où ces dernières dépendent de la revendication 4, caractérisé en ce que la fixation du composant électronique est faite à l'aide de colle conductrice à l'argent.

8. Boîtier selon l'une des revendications 5 à 7, caractérisé en ce que le capot de protection du composant électronique est formé d'une seule pièce et en ce que sa fixation est faite au moyen de colle époxy.

9. Boîtier selon l'une des revendications 5 à 7, caractérisé en ce que le capot de protection du composant est formé de deux pièces, une entretoise et un couvercle, en ce que l'entretoise est fixée sur la couche protectrice du circuit multicouches à l'aide d'une encre identique à celle qui constitue cette couche, et en ce que le couvercle est fixé sur l'entretoise à l'aide de colle époxy.

10. Boîtier selon l'une des revendications 1 à 4, caractérisé en ce que l'alliage métallique de fixation des broches est l'argent-cuivre-nickel.

11. Boîtier selon la revendication 10 dans la mesure où cette dernière dépend de la revendication 4, caractérisé en ce que la fixation du composant électronique est faite à l'aide d'un eutectique or-silicium.

12. Boîtier selon la revendication 9 ou 10, caractérisé en ce que le capot de protection du composant est formé d'une seule pièce et en ce que sa fixation est faite à l'aide de l'alliage or-étain.

13. Boîtier selon l'une des revendications 4 à 12, caractérisé en ce que les fils souples de liaison des bornes du composant électronique aux extrémités des conducteurs du circuit multicouches sont en or, et en ce que leur fixation est le résultat d'un câblage ultra-sonique.

14. Boîtier selon l'une des revendications précédentes caractérisé en ce que les pointes des broches sont apparentes du côté du substrat qui porte le circuit multicouches.

15. Procédé de réalisation d'un boîtier conforme à la revendication 1, caractérisé en ce qu'il comprend les étapes de :

a) formation d'un substrat en céramique,

b) perçage dans le substrat, de trous destinés à servir de logement aux broches de fixation du boîtier, tout en ménageant une plage prévue pour recevoir le composant électronique,

c) métallisation des trous, et formation de couronnes conductrices autour des trous sur chaque face du substrat, ces opérations étant réalisées par sérigraphie à l'aide d'une encre conductrice constituée au moins de cuivre et d'un matériau vitrocristallin, à cuire sous atmosphère neutre à une température inférieure à la température de fusion du cuivre, et ces opérations comprenant le dépôt, au niveau du débouché des trous, d'une quantité de l'encre conductrice, la diffusion de cette encre dans les trous, par exemple par aspiration, et la cuisson des couches ainsi réalisées,

d) dépôt d'une première couche conductrice, selon une configuration prévue pour former des conducteurs destinés à assurer la liaison entre une partie des bornes du composant électronique et une partie des broches, en laissant libre la plage prévue pour recevoir le composant électronique, ce dépôt étant réalisé par sérigraphie à l'aide d'une encre conductrice au cuivre identique à, ou compatible avec, l'encre de métallisation des trous et des couronnes, et cuisson de cette couche,

e) dépôt d'une couche isolante, selon une configuration prévue pour isoler la précédente couche conductrice de la couche conductrice suivante, en laissant libre la plage prévue pour recevoir le composant électronique, ainsi que les couronnes conductrices et les extrémités des conducteurs se trouvant en regard des bornes du composant, ce dépôt étant réalisé par sérigraphie à l'aide d'une encre isolante vitrocristalline à cuire sous atmosphère neutre à une température compatible avec celle de l'encre conductrice, cette encre présentant un coefficient de dilatation très voisin de celui du substrat jusqu'à la température de cuisson de la couche, et cuisson de cette couche,

f) dépôts alternés de couches respectivement conductrices et isolantes selon une configuration prévue pour obtenir le réseau de conducteurs nécessaire à la connexion des bornes du composant électronique aux broches du boîtier, en laissant libre la plage prévue pour recevoir le composant électronique, ainsi que les couronnes conductrices et les extrémités des conducteurs se trouvant en regard des bornes du composant, ces dépôts étant réalisés par sérigraphie à l'aide d'encres alternativement conductrices et isolantes identiques à, ou compatibles avec, les encres formant les couches précédentes, en terminant par une couche protectrice isolante, et cuisson de ces couches une à une,

g) protection provisoire des zones constituées par la plage prévue pour le composant électronique et les extrémités des conducteurs en regard de cette plage, à l'aide d'un vernis résistant à la soudure prévue pour la fixation des broches,

h) mise en place des broches métalliques formées d'une tige munie d'une tête plate, la tige traversant le substrat dans les trous et dépassant d'une des faces d'une longueur suffisant à assurer la fixation du boîtier, et la tête plate prenant appui sur la couronne située sur l'autre face du substrat, et soudure des broches à l'aide d'un alliage métallique compatible avec la métallisation des trous et des couronnes, dont la température de fusion est inférieure à, ou de l'ordre de, la température de cuisson des couches du circuit,

i) élimination du vernis de protection,

j) mise en place et fixation du composant électronique sur la plage réservée sur le substrat,

k) câblage de fils métalliques souples entre les bornes du composant électronique et les extrémités laissées libres des conducteurs du circuit multicouches,

l) fixation du capot de protection du composant électronique.

16. Procédé de réalisation selon la revendication 15, d'un boîtier conforme à la revendication 2, caractérisé en ce que le substrat est formé en alumine.

17. Procédé de réalisation selon l'une des revendications 15 ou 16, d'un boîtier conforme à la revendication 3, caractérisé en ce que les broches sont réalisées en fer-nickel-cobalt et étamées en surface.

18. Procédé de réalisation selon l'une des revendications 15 à 17 d'un boîtier conforme à la revendication 4, caractérisé en ce qu'un plan de masse en cuivre, prévu pour recevoir le composant électronique, est réalisé sur la même face du substrat que le circuit multicouches, en même temps que la première couche conductrice, et par sérigraphie à l'aide d'une encre conductrice au cuivre identique à, ou compatible avec, l'encre conductrice du circuit multicouches.

19. Procédé de réalisation selon l'une des revendications 15 à 18, d'un boîtier conforme à la revendication 5, caractérisé en ce que la fixation des broches est faite à l'aide de soudure étain-plomb et de flux non activé, à 230 °C par une méthode choisie entre la méthode dite « au tremper » et la méthode dite « à la vague ».

20. Procédé de réalisation selon l'une des revendications 15 à 18, d'un boîtier conforme à la revendication 6, caractérisé en ce que la fixation des broches est faite à l'aide de l'alliage étain-plomb-argent inclus dans une encre sérigraphiable contenant un flux moyennement actif, cette fixation comprenant le dépôt de cette encre, de chaque côté du substrat, sur les couronnes, en quantité suffisante pour le remplissage de l'intervalle entre la paroi du trou et la broche, et pour former des congès de soudure entre la broche et les couronnes, et comprenant la refusion de cet alliage à 320 °C sous atmosphère neutre.

21. Procédé de réalisation selon l'une des revendications 19 ou 20, dans ls mesure où elles dépendent de la revendication 18, d'un boîtier conforme à la revendication 7, caractérisé en ce que le composant électronique est fixé sur le plan de masse à l'aide de colle conductrice à l'argent et chauffage sous atmosphère neutre.

22. Procédé de réalisation selon l'une des revendications 18 à 21, d'un boîtier conforme à la revendication 8, caractérisé en ce que, le capot du composant étant fait d'une seule pièce, ce capot est assujetti par de la colle époxy, polymérisée à 150 °C sous atmosphère neutre.

23. Procédé de réalisation selon l'une des revendications 18 à 21, d'un boîtier conforme à la revendication 9, caractérisé en ce que, le capot de protection du composant étant formé de deux pièces, une entretoise et un couvercle, l'entretoise est fixée sur la couche protectrice du circuit multicouches à l'aide de la même encre qui forme cette couche protectrice et avant l'opération de protection des zones métalliques par un vernis, et le couvercle est fixé sur l'entretoise en dernière opération de réalisation du boîtier, à l'aide de colle époxy, polymérisée à 150 °C sous atmosphère neutre.

24. Procédé de réalisation selon l'une des revendications 15 à 18 d'un boîtier conforme à la revendication 10, caractérisé en ce que la fixation des broches est faite à l'aide de l'alliage argent-cuivre-nickel, des préformes circulaires constituées de cet alliage étant insérées entre la tête de

ls broche et la face du substrat contre laquelle la tête prend appui, et la soudure étant faite à une température comprise entre 780 °C et 795 °C.

25. Procédé de réalisation selon la revendication 24 dans la mesure où elle dépend de la revendication 18, d'un boîtier conforme à la revendication 11, caractérisé en ce que la fixation du composant est faite à l'aide d'un eutectique or-silicium à une température comprise entre 420 et 450 °C.

26. Procédé de réalisation selon l'une des revendications 24 ou 25 d'un boîtier conforme à la revendication 12, caractérisé en ce que le capot de protection du composant est fait d'une seule pièce et assujetti sur la couche protectrice du circuit multicouches à l'aide d'un alliage or-étain à 350 °C.

27. Procédé de réalisation selon l'une des revendications 15 à 26 d'un boîtier conforme à la revendication 13, caractérisé en ce que les fils souples de liaison des bornes du composant électronique aux extrémités des conducteurs sont en or, et en ce que leur fixation est effectuée par câblage ultra-sonique, avec ou sans chauffage.

28. Procédé de réalisation selon l'une des revendications 15 à 27, d'un boîtier conforme à la revendication 14, caractérisé en ce que les broches sont introduites et fixées dans les trous du boîtier de manière à ce que les pointes soient apparentes du côté du substrat qui porte le circuit multicouches.

29. Procédé de réalisation selon l'une des revendications 15 à 28, caractérisé en ce que la température de cuisson de la couche protectrice isolante du circuit multicouches est de l'ordre de 550 °C et en ce que la température de cuisson des autres couches conductrices et isolantes est de l'ordre de 850 °C.

30. Procédé de réalisation selon l'une des revendications 15 à 29, caractérisé en ce que l'atmosphère neutre utilisée pour réaliser les différentes étapes du procédé est l'azote.

31. Procédé de réalisation selon l'une des revendications 15 à 30, caractérisé en ce que les conducteurs sont réalisés à l'aide d'une couche conductrice de 15μm environ, et en ce que l'isolation entre couches conductrices est obtenue par la superposition de deux couches isolantes formant une épaisseur totale d'environ 40 μm.

## Claims

1. A housing for an electronic device including a ceramic substrate on which a multilayer circuit is deposited by screen-printing using materials which are alternately conductors and insulators, which circuit serves to bring about the connection between the terminals of the said electronic device which is secured to the substrate and the mounting pins of the housing, which are provided in metallized holes in the substrate, which holes are provided on each side of the substrate with conducting rings, the metallization of the holes and the rings being carried out by screen-printing using a conducting material which is compatible with the conducting material of the multilayer circuit, characterized in that the conducting material is a compound which can be screen-printed and which is formed from, at least, copper and a vitreous-crystalline material, which compound is to be fired in a neutral atmosphere at a temperature which is lower than the melting temperature of copper, in that the insulating material is a vitreous-crystalline screen-printable compound which is to be fired in a neutral atmosphere at a temperature which is suited for the conducting material, the said insulating material having a coefficient of expansion which is adapted, up to its firing temperature, to that of the substrate, in that the last layer of the circuit is a protective insulating vitreous-crystalline layer, in that the pins have the shape of a shank provided with a flat head, which shank passes through the holes in the substrate and sufficiently projects from one of the faces to ensure a proper fixation of the housing, the flat head resting on the ring which is located at the other side of the substrate, in that the pins are fixed by means of a metal alloy which is compatible with the metallization of the holes and the rings, the melting temperature of which alloy is substantially the same or lower than the firing temperature of the circuit layers, in that the terminals of the said electronic device located on the substrate are connected to the ends of the conductors by means of flexible wires, which ends are left free during the manufacture of the multilayer circuit, and in that the electronic device is protected by a cap.

2. A housing as claimed in Claim 1, characterized in that the substrate is of aluminium oxide.

3. A housing as claimed in one of the Claims 1 or 2, characterized in that the pins are of iron/nickel/cobalt and have tin-plated surfaces.

4. A housing as claimed in any one of the Claims 1 to 3, characterized in that the electronic device is fitted on a copper mounting area, which is fabricated on the same face of the substrate as the multilayer circuit, by means of screen-printing using a conducting copper-containing ink which is identical to, or compatible with, the conducting ink of the multilayer circuit.

5. A housing as claimed in any one of the Claims 1 to 4, characterized in that the pins are fixed by means of a tin/lead metal alloy.

6. A housing as claimed in any one of the Claims 1 to 4, characterized in that the metal alloy used for fixing the pins is tin/lead/silver contained in a screen-printable compound.

7. A housing as claimed in any one of the Claims 5 or 6, in so far as these Claims depend upon Claim 4, characterized in that the mounting of the electronic device is carried out using a conducting silver adhesive.

8. A housing as claimed in any one of the Claims 5 to 7, characterized in that the protective cap of the electronic device is formed from a single piece and in that it is fitted using an epoxy adhesive.

9. A housing as claimed in any one of the Claims 5 to 7, characterized in that the protective cap of the device consists of two parts, a spacer and a cover, in that the spacer is fixed on the protective layer of the multilayer circuit by means of ink which is identical to the ink which constitutes the said layer, and in that the cover is fixed on the spacer using an epoxy adhesive.

10. A housing as claimed in any one of the Claims 1 to 4, characterized in that the metal alloy used for fixing the pins is silver/copper/nickel.

11. A housing as claimed in Claim 10 in so far as the said Claim depends on Claim 4, characterized in that the electronic device is fitted using a gold-silicon eutectic.

12. A housing as claimed in Claim 9 or 10, characterized in that the protective cap of the device is in one piece and in that it is fixed using a gold-tin alloy.

13. A housing as claimed in any one of the Claims 4 to 12, characterized in that the flexible wires for connecting the terminals of the electronic device to the ends of the conductors of the multilayer circuit are of gold and in that they are provided by an ultrasonic connecting method.

14. A housing as claimed in any one of the preceding Claims characterized in that the tips of the pins project from that side of the substrate which carries the multilayer circuit.

15. A method of manufacturing a housing in accordance with Claim 1, characterized in that it comprises the following stages :

a) forming a ceramic substrate,

b) piercing holes in the substrate to accommodate the mounting pins of the housing while providing an area for the accommodation of the electronic device,

c) metallizing the holes and forming conducting rings around the holes on each side of the substrate, these operations being carried out by screen-printing using a conducting ink which is made of, at least, copper and a vitreous-crystalline material, and which is to be fired in a neutral atmosphere at a temperature which is lower than the melting temperature of copper, which operations comprise depositing an amount of conducting ink at the opening of the holes, diffusing the ink in the holes, for example by reflowing, and firing the layers thus obtained,

d) depositing a first conducting layer according to such a pattern that conductors are formed for interconnecting part of the terminals of the electronic device to part of the pins, leaving free the area for accommodating the electronic device, the said deposition being carried out by screen-printing using a conducting ink comprising copper, which ink is identical to, or compatible with, the ink used for metallising the holes and the rings, and firing the said layer,

e) depositing an insulating layer according to such a pattern that the preceding conducting layer is insulated from the next conducting layer, thereby leaving free the area for accommodating the electronic device as well as the conducting rings and the ends of the conductors which are located opposite the terminals of the device, the said deposition process being carried out by screen-printing using an insulating vitreous-crystalline ink which is to be fired in a neutral atmosphere at a temperature compatible with that of the conducting ink, the said ink having a coefficient of expansion which is very close to that of the substrate up to the firing temperature of the layer, and firing the said layer,

f) alternately depositing conducting and insulating layers, respectively, according to such a pattern that the network of conductors necessary for interconnecting the terminals of the electronic device and the pins of the housing is obtained, thereby leaving free the area for accommodating the electronic device as well as the conducting rings and the ends of the conductors located opposite the terminals of the device, these deposition processes being carried out by means of screen-printing using types of ink which are by turns conductive and insulative, and which are identical to, or compatible with, the types of ink which form the preceding layers, the last layer being a protective insulating layer, and firing the said layers one by one,

g) temporarily protecting the zones which are formed by the area for accommodating the electronic device and the ends of the conductors located opposite the said area, using a varnish which is resistant to the solder used for fixing the pins,

h) locating the metal pins which consist of a shank provided with a flat head, the shank passing through the substrate at the location of the holes thereby sufficiently projecting from one of the faces to ensure a proper fixation of the housing, the flat head being supported by the ring located at the other face of the substrate, and, subsequently, soldering the pins using a metal alloy which is compatible with the metal coating of the holes and rings, the melting temperature being lower than or substantially equal to the firing temperature of the circuit layers,

i) removing the protective varnish,

j) locating and fixing the electronic device in the area reserved at the substrate,

k) providing flexible metal wires between the terminals of the electronic device and the ends of the conductors of the multilayer circuit which are left free,

l) fixing the protective cap of the electronic device.

16. A manufacturing method, as claimed in Claim 15, of a housing in accordance with Claim 2, characterized in that the substrate is made of aluminium oxide.

17. A manufacturing method, as claimed in Claim 15 or 16, of a housing in accordance with Claim 3, characterized in that the pins are made of iron-nickel-cobalt and that the surface is thin-plated.

18. A manufacturing method, as claimed in any one of the Claims 15 to 17, of a housing in accordance with Claim 4, characterized in that a copper mounting area on which the electronic device is to be mounted, is provided on the same face of the substrate as the multilayer circuit at the same time as the first conducting layer, and by screen-printing using a conducting copper-containing ink which is identical to, or compatible with, the conducting ink of the multilayer circuit.

19. A manufacturing method, in accordance with any one of the Claims 15 to 18, of a housing in accordance with Claim 5, characterized in that the pins are fixed using a tin/lead solder and non-activated flux by either « dip soldering » or « wave soldering », at a temperature of 230 °C.

20. A manufacturing method, as claimed in any one of the Claims 15 to 18, of a housing in accordance with Claim 6, characterized in that the pins are fixed using a tin/lead/silver alloy which is included in a screen-printable ink comprising an averagely active flux, which fixation comprises depositing the said ink, on each side of the substrate, on the rings, in an amount which suffices to fill up the interval between the wall of the hole and the pin and to form solder fillets between the pin and the rings, and comprising remelting of the said alloy in a neutral atmosphere at a temperature of 320 °C.

21. A manufacturing method, as claimed in Claim 19, or 20 in so far as they depend on Claim 18, of a housing in accordance with Claim 7, characterized in that the electronic device is fitted on the mounting area using a conducting silver-adhesive and applying heat in a neutral atmosphere.

22. A manufacturing method, as claimed in any one of the Claims 18 to 21, of a housing in accordance with Claim 8, characterized in that the cap of the device, which is in one piece, is fitted by an epoxy adhesive which is polymerized in a neutral atmosphere at 150 °C.

23. A manufacturing method, as claimed in any one of the Claims 18 to 21, of a housing in accordance with Claim 9, characterized in that the protective cap of the device is in two parts, i. e. a spacer and a cover, the spacer is fitted on the protective layer of the multilayer circuit by means of the same ink as that used to form the said protective layer and prior to protecting the metal zones by a varnish, and the cover is fitted on the spacer in the last operation in the manufacture of the housing, using an epoxy adhesive which is polymerised in a neutral atmosphere at a temperature of 150 °C.

24. A manufacturing method, as claimed in any one of the Claims 15 to 18, of a housing in accordance with Claim 10, characterized in that the pins are fixed using a silver/copper/nickel alloy, round preforms made of the said alloy being inserted between the head of the pin and the face of the substrate which supports the head, and the soldering process being carried out at a temperature ranging from 780 °C to 795 °C.

25. A manufacturing method, as claimed in Claim 24 in so far as it depends on Claim 18, of a housing in accordance with Claim 11, characterized in that the device is fitted using a gold-silicon eutectic at a temperature ranging from 420 to 450 °C.

26. A manufacturing method, as claimed in Claim 24 or 25, of a housing in accordance with Claim 12, characterized in that the protective cap of the device is in one piece and is fitted on the protecting layer of the multilayer circuit by means of a gold/tin alloy at a temperature of 350 °C.

27. A manufacturing method, as claimed in any one of the Claims 15 to 26, of a housing in accordance with Claim 13, characterized in that the flexible wires for connecting the terminals of the electronic device to the ends of the conductors are made of gold and in that they are fixed by an ultrasonic connecting method, with or without the use of heat.

28. A manufacturing method, as claimed in any one of the Claims 15 to 27, of a housing in accordance with Claim 14, characterized in that the pins are introduced and fixed in the holes of the housing in such a way that the tips project from the side of the substrate which carries the multilayer circuit.

29. A manufacturing method as claimed in any one of the Claims 15 to 28, characterized in that the firing temperature of the insulating protective layer of the multilayer circuit is of the order of 550 °C and that the firing temperature of the other insulating conducting layers is of the order of 850 °C.

30. A manufacturing method as claimed in any one of the Claims 15 to 29, characterized in that the neutral atmosphere used to carry out the various stages of the method is a nitrogen atmosphere.

31. A manufacturing method as claimed in any one of the Claims 15 to 30, characterized in that the conductors are obtained by means of a conducting layer of approximately 15$\mu$m, and in that the insulation between conducting layers is obtained by superposing two insulating layers having a total thickness of approximately 40$\mu$m.

**Patentansprüche**

1. Gehäuse für ein elektronisches Bauelement mit einem keramischen Substrat, auf dem eine Mehrschichtschaltungsanordnung niedergeschlagen ist, die im Siebdruckverfahren hergestellt ist und zwar mit Hilfe eines abwechselnd leitenden und isolierenden Materials zur Verbindung zwischen den Anschlussstellen des elektronischen Bauelementes, das auf dem Substrat befestigt ist und den Befestigungsstiften des Gehäuses, die in dem Substrat in metallisierten Löchern mit leitenden Kragen vorgesehen sind und zwar an jeder Seite des Substrats, wobei die Metallisierung der Löcher und der Kragen im Siebdruckverfahren mit Hilfe eines leitenden Materials verwirklicht worden ist, wobei dieses Material mit dem leitenden Material, das die Mehrschichtschaltungsanordnung bildet, vereinigbar ist, dadurch gekennzeichnet, dass das leitende Material eine Siebdruckverbindung ist, die durch mindestens Kupfer und einer Glaskeramik gebildet wird, die in einer neutralen Atmosphäre gebrannt werden muss und zwar bei einer Temperatur, die niedriger ist als die Schmelztemperatur des Kupfers, dass das isolierende Material eine glaskeramische Siebdruckverbindung ist, die in einer neutralen Atmosphäre bei einer Temperatur gebrannt werden muss, die kompatibel ist mit dem leitenden Material, wobei dieses isolierende Material einen Ausdehnungskoeffizienten aufweist, der bis an die Brenntemperatur des Substrats angepasst ist, dass die letzte Schicht der Schaltungsanordnung eine glaskeramische isolierende Schutzschicht ist, dass die Stifte in Form eines Stabes mit flachem Kopf sind, wobei dieser Stab durch die Löcher des Substrats hindurch und über eine ausreichende Länge aus einer der Flächen zum Befestigen des Gehäuses hinausragt und dass der flache Kopf auf den Kragen stützt, der auf der anderen Seite des Substrats liegt, dass die Stifte mit Hilfe einer Metalllegierung befestigt sind, die mit der Metallisierung der Löcher und der leitenden Kragen vereinigbar ist, und deren Schmelztemperatur niedriger ist als die oder in der Grössenordnung der Brenntemperatur der Schichten der Schaltungsanordnung liegt, dass das elektronische Bauelement in dem Substrat angeordnet ist, die Anschlussstellen dieses Bauelementes durch geschmeidige Drähte mit den Enden der während der Bearbeitung der Mehrschichtschaltung frei gelassenen Leiter verbunden sind und dass die elektronischen Bauelemente durch eine Kappe geschützt werden.

2. Gehäuse nach Anspruch 1, dadurch gekennzeichnet, dass das Substrat aus Aluminiumoxid besteht.

3. Gehäuse nach einem der Ansprüche 1 oder 2, dadurch gekennzeichnet, dass die Stifte aus Eisen-Nickel-Kobalt bestehen und ihre Oberfläche verzinnt ist.

4. Gehäuse nach einem der Ansprüche 1 bis 3, dadurch gekennzeichnet, dass das elektronische Bauelement auf einer Kupfermassenfläche befestigt ist, die im Siebdruckverfahren mit Hilfe einer mit Kupfer leitenden, der leitenden Tinte der Mehrschichtschaltung entsprechenden oder zu derselben kompatiblen Tinte auf derselben Fläche wie die Mehrschichtschaltung angebracht ist.

5. Gehäuse nach einem der Ansprüche 1 bis 4, dadurch gekennzeichnet, dass die Metalllegierung zum Befestigen der Stifte Zinn-Blei ist.

6. Gehäuse nach einem der Ansprüche 1 bis 4, dadurch gekennzeichnet, dass die Metalllegierung zum Befestigen der Stifte Zinn-Blei-Silber ist, das sich in einer Siebdruckverbindung befindet.

7. Gehäuse nach einem der Ansprüche 5 oder 6, insofern diese letzteren von Anspruch 4 abhängig sind, dadurch gekennzeichnet, dass die Befestigung des elektronischen Bauelementes mit Hilfe eines leitenden Silberklebers erfolgt.

8. Gehäuse nach einem der Ansprüche 5 bis 7, dadurch gekennzeichnet, dass die Schutzkappe des elektronischen Bauelementes aus nur einem Teil besteht und dass die Befestigung derselben mit Hilfe eines Epoxyklebers erfolgt.

9. Gehäuse nach einem der Ansprüche 5 bis 7, dadurch gekennzeichnet, dass die Schutzkappe des Bauelementes aus zwei Teilen besteht, einem Querteil und einem Deckel, dass der Querteil mit Hilfe einer Tinte auf der Schutzschicht der Mehrschichtschaltung befestigt ist, die der diese Schicht bildenden Tinte entspricht und dass der Deckel mit Hilfe eines Epoxyklebers auf dem Querteil befestigt ist.

10. Gehäuse nach einem der Ansprüche 1 bis 4, dadurch gekennzeichnet, dass die Metallegierung zum Befestigen der Stifte Silber-Kupfer-Nickel ist.

11. Gehäuse nach Anspruch 10, insofern dieser von Anspruch 4 abhängig ist, dadurch gekennzeichnet, dass die Befestigung des elektronischen Bauelementes mit Hilfe eines Gold-Silizium-Eutektikums erfolgt.

12. Gehäuse nach Anspruch 9 oder 10, dadurch gekennzeichnet, dass die Schutzkappe des Bauelementes aus nur einem Teil besteht und dass die Befestigung desselben mit Hilfe einer Gold-Zinnlegierung erfolgt.

13. Gehäuse nach einem der Ansprüche 4 bis 12, dadurch gekennzeichnet, dass zum Verbinden der Anschlusspunkte des elektronischen Bauelementes mit den Enden der Leiter der Mehrschichtschaltung biegsame Drähte aus Gold sind und dass ihre Befestigung das Ergebnis einer Ultraschallverdrahtung ist.

14. Gehäuse nach einem der vorstehenden Ansprüche, dadurch gekennzeichnet, dass die Spitzen der Stifte auf der Seite des Substrats sichtbar sind, welche die Mehrschichtschaltung trägt.

15. Verfahren zum Herstellen eines Gehäuses nach Anspruch 1, dadurch gekennzeichnet, dass dieses verfahren die folgenden Schritte aufweist :

a) das Bilden des keramischen Substrats,

b) das Bohren von Löchern in dem Substrat, die als Raum für die Befestigungsstifte des Gehäuses wirksam sind, wobei eine Fläche vorgesehen wird zum Befestigen des elektronischen Bauelementes,

c) Metallisierung der Löcher und Bildung der leitenden Kragen um die Löcher herum und zwar auf jeder Seite des Substrats, wobei diese vorgänge im Siebdruckverfahren durchgeführt werden und zwar mit Hilfe einer leitenden Tinte, die aus Kupfer und einem glaskeramischen Material besteht, wobei diese Werkstoffe in einer neutralen Atmosphäre gebrannt werden müssen und zwar bei einer Temperatur, die niedriger ist als die Schmelztemperatur des Kupfers und wobei diese Vorgänge zur Höhe der Mündung der Löcher das Anbringen einer Menge leitender Tinte, das Diffundieren dieser Tinte in den Löchern beispielsweise durch Hineinsaugen und das Brennen der auf diese Weise erhaltenden Schichten,

d) das Anbringen einer ersten leitenden Schicht entsprechend einem Muster, das zum Bilden von Leitern vorgesehen ist, die für die Verbindung zwischen einem Teil der Anschlüsse des elektronischen Bauelementes und einem Teil der Stifte sorgen müssen, wobei die Fläche, die zum Erhalten des elektronischen Bauelementes bestimmt ist, unbedeckt bleibt, wobei dieses Anbringen der betreffenden Schicht im Siebdruckverfahren erfolgt und zwar mit Hilfe einer leitenden Tinte auf Basis von Kupfer, wobei diese Tinte der Metallisierungstinte der Löcher und der Kragen entspricht bzw. kompatibel damit ist, sowie das Brennen dieser Schicht,

e) das Anbringen einer Isolierschicht entsprechend einem Muster, das zum Isolieren der vorhergehenden leitenden Schicht gegenüber der nachfolgenden leitenden Schicht, wobei die Fläche zum Erhalten des elektronischen Bauelementes frei bleibt, ebenso wie die leitenden Kragen und die Enden der Leiter, die sich gegenüber den Anschlüssen des Bauelementes befinden, wobei dieses Anbringen im Siebdruckverfahren mit Hilfe einer glaskeramischen isolierenden Einbrenntinte erfolgt und zwar in einer neutralen Atmosphäre bei einer Temperatur, die kompatibel ist mit der der leitenden Tinte, wobei diese Tinte einen Ausdehnungskoeffizienten aufweist, der bis zur Brenntemperatur der Schicht sehr nahe bei dem des Substrats liegt sowie das Brennen dieser Schicht,

f) das wechselweise Anbringen leitender bzw. isolierender Schichten und zwar entsprechend einem Muster, das zum Erhalten des Leiternetzwerkes vorgesehen ist, das notwendig ist für die verbindung der Anschlüsse des elektronischen Bauelementes mit den Stiften des Gehäuses, wobei die Fläche zum Erhalten des elektronischen Bauelementes frei bleibt, ebenso wie die leitenden Kragen und die Enden der Leiter, die sich gegenüber den Anschlüssen des Bauelementes befinden, wobei dieses Niederschlagen im Siebdruckverfahren erfolgt und zwar mit Hilfe leitender bzw. isolierender Tinten, die denen der vorhergehenden Schichten entsprechen bzw. kompatibel mit denselben sind, wonach letzten Enden eine schützende Isolierschicht angebracht wird, wonach diese Schichten eine nach der anderen gebrannt wird,

g) das Anbringen einer einstweiligen Schutzschicht über die Zonen, die durch die Fläche für das elektronische Bauelement und die Enden der Leiter gegenüber dieser Fläche gebildet werden mit Hilfe eines Lackes, der gegen einen Lötvorgang zum Befestigen der Stifte beständig ist,

h) das an ihren Platz bringen der Metallstifte, die durch einen Stab mit einem flachen Kopf gebildet werden, wobei dieser Stab in den Löchern durch das Substrat hindurchgeht und aus einer der Flächen hinausragt und zwar über eine ausreichende Länge zum Befestigen des Gehäuses und wobei der flache Kopf sich auf den Kragen stützt, der sich auf der anderen Fläche des Substrates befindet sowie das Verlöten der Stifte mit Hilfe einer Metallegierung, die mit der Metallisierung der Löcher und der Kragen kompatibel ist, wobei die Schmelztemperatur niedriger ist als die oder der Grössenordnung ist der Brenntemperatur der Schaltungsschichten,

i) das Entfernen des Schutzlackes,

j) das an seinen Platz bringen sowie Befestigen des elektronischen Bauelementes auf der auf dem Substrat dazu reservierten Fläche,

k) das Anbringen biegsamer Metalldrähte zwischen den Anschlüssen des elektronischen Bauelementes und den freien Enden der Leiter der Mehrschichtschaltung,

l) das Befestigen der Schutzkappe für das elektronische Bauelement.

16. Verfahren nach Anspruch 15 zum Herstellen eines Gehäuses nach Anspruch 2, dadurch gekennzeichnet, dass das Substrat aus Aluminiumoxid besteht.

17. Verfahren nach einem der Ansprüche 15 oder 16 zum Herstellen eines Gehäuses nach Anspruch 3, dadurch gekennzeichnet, dass die Stifte aus Eisen-Nickel-Kobalt hergestellt und an der Oberfläche verzinnt sind.

18. Verfahren nach einem der Ansprüche 15 bis 17 zum Herstellen eines Gehäuses nach Anspruch 4, dadurch gekennzeichnet, dass eine Kupfer-Massenfläche, die zum Anbringen des elektronischen Bauelementes vorgesehen ist, auf derselben Seite des Substrats angebracht ist wie die Mehrschichtschaltung und zwar gleichzeitig mit der ersten leitenden Schicht und im Siebdruckverfahren mit Hilfe einer leitenden Kupfertinte entsprechend der oder kompatibel mit der leitenden Tinte der Mehrschichtschaltung.

19. Verfahren nach einem der Ansprüche 15 bis 18 zum Herstellen eines Gehäuses nach Anspruch 5, dadurch gekennzeichnet, dass die Befestigung der Stifte mit Hilfe eines Zinn-Blei-Lots und eines nicht aktivierten Flussmittels erfolgt und zwar bei 230°C entweder nach einem Verfahren, das als Tauchlötverfahren bekannt ist oder nach einem verfahren, das als Schwellenlötverfahren bezeichnet wird.

20. Verfahren nach einem der Ansprüche 15 bis 18 zum Herstellen eines Gehäuses nach Anspruch 6, dadurch gekennzeichnet, dass die Befestigung der Stifte mit Hilfe einer Zinn-Blei-Silberlegierung in einer Siebdrucktinte mit einem mittelmässig aktiven Flussmittel erfolgt, wobei diese Befestigung das Anbringen dieser Tinte auf jeder Seite des Substrats auf den Kragen und zwar in einer Menge, die zum Füllen des Raumes zwischen der Wand des Loches und den Stiften sowie zum Bilden von Lötverbindungen zwischen dem Stift und den Kragen sowie das abermalige Schmelzen dieser Legierung bei 320°C in neutraler Atmosphäre umfasst.

21. Verfahren nach einem der Ansprüche 19 oder 20 insofern abhängig vom Anspruch 18 zum Herstellen eines Gehäuses nach Anspruch 7, dadurch gekennzeichnet, dass das elektronische Bauelement mit Hilfe eines leitenden Silberklebers und durch Erhitzung in neutraler Atmosphäre auf der Massenfläche befestigt wird.

22. Verfahren nach einem der Ansprüche 18 bis 21 zum Herstellen eines Gehäuses nach Anspruch 8, dadurch gekennzeichnet, dass weil die Schutzkappe des Bauelementes aus nur einem Teil besteht, diese Kappe mit Epoxykleber befestigt ist, der bei 150°C in neutraler Atmosphäre polymerisiert ist.

23. Verfahren nach einem der Ansprüche 18 bis 21 zum Herstellen eines Gehäuses nach Anspruch 9, dadurch gekennzeichnet, dass weil die Schutzkappe des Bauelementes aus zwei Teilen besteht und zwar aus einem Träger und einem Deckel, wird der Träger mit Hilfe derselben, die Schutzschicht bildenden Tinte auf der Schutzschicht der Mehrschichtschaltung und vor dem Schutzvorgang der metallischen Zonen mittels eines Lackes befestigt, wobei der Deckel bei der letzten Bearbeitung zum Herstellen des Gehäuses mit Hilfe von Epoxykleber, der in neutraler Atmosphäre bei 150°C polymerisiert ist, befestigt wird.

24. Verfahren nach einem der Ansprüche 15 bis 18 zum Herstellen eines Gehäuses nach Anspruch 10, dadurch gekennzeichnet, dass die Befestigung der Stifte mit Hilfe der Silber-Kupfer-Nickellegierung erfolgt, wobei kreisrunde Vorformen, die aus dieser Legierung bestehen, zwischen dem Kopf des Stiftes und der Fläche des Substrats, auf welche der Kopf sich stützen wird, vorgesehen werden und das Verlöten bei einer Temperatur erfolgt, die zwischen 780°C und 795°C liegt.

25. Verfahren nach Anspruch 24, insofern abhängig vom Anspruch 18, zum Herstellen eines Gehäuses nach Anspruch 11, dadurch gekennzeichnet, dass die Befestigung des Bauelementes mit einem Gold-Silizium-Eutektikum erfolgt und zwar bei einer Temperatur, die zwischen 420°C und 450°C liegt.

26. Verfahren nach einem der Ansprüche 24 oder 25 zum Herstellen eines Gehäuses nach Anspruch 12, dadurch gekennzeichnet, dass die Schutzkappe des Bauelementes aus nur einem Teil besteht und mit Hilfe einer Gold-Zinnlegierung bei 250°C auf der Schutzschicht der Mehrschichtschaltung befestigt ist.

27. Verfahren nach einem der Ansprüche 15 bis 26 zum Herstellen eines Gehäuses nach Anspruch 13, dadurch gekennzeichnet, dass die geschmeidigen Verbindungsdrähte zum Verbinden der Stifte des elektronischen Bauelementes mit den Enden der Leiter aus Gold bestehen und dass die Befestigung mit oder ohne Erhitzung mit Hilfe von Ultraschallverdrahtung erfolgt.

28. Verfahren nach einem der Ansprüche 15 bis 27 zum Herstellen eines Gehäuses nach Anspruch 14, dadurch gekennzeichnet, dass die Stifte in die Löcher des Gehäuses eingeführt und darin befestigt sind und zwar derart, dass die Enden auf derjenigen Seite des Substrats sichtbar sind, auf der die Mehrschichtschaltung vorhanden ist.

29. Verfahren nach einem der Ansprüche 15 bis 28, dadurch gekennzeichnet, dass die Brenntemperatur der isolierenden Schutzschicht der Mehrschichtschaltung in der Grössenordnung von 550°C liegt und dass die Brenntemperatur der weiteren leitenden und isolierenden Schichten in der Grössenordnung von 850°C liegt.

30. Verfahren nach einem der Ansprüche 15 bis 29, dadurch gekennzeichnet, dass die zum Verwirklichen der jeweiligen verfahrensschritte verwendete neutrale Atmosphäre Stickstoff ist.

31. Verfahren nach einem der Ansprüche 15 bis 30, dadurch gekennzeichnet, dass die Leiter mit Hilfe einer leitenden Schicht mit einer Dicke von etwa 15μm hergestellt werden und dass die Isolierung zwischen leitenden Schichten durch die Überlagerung der zwei isolierenden Schichten erhalten wird, die eine Gesamtdicke von etwa 40 μm aufweisen.

FIG.1

FIG.2

FIG.3A

FIG.3B